# EUROPEAN PATENT APPLICATION

(11) **EP 4 808 327 A1**
(43) Date of publication of application: **16.09.2026**
(21) Application number: 24948344.7
(22) Date of filing: 14.08.2024
(51) Int. Cl.: H10K 59/40

(54) **DISPLAY PANEL AND DISPLAY DEVICE**

(30) Priority: 23.07.2024 CN 202410997757
(71) Applicant: Wuhan Tianma Microelectronics Co., Ltd., Wuhan, Hubei 430205 (CN)
(72) Inventor: YE, Yalong, Wuhan, Hubei 430205 (CN); FAN, Yanyun, Wuhan, Hubei 430205 (CN); ZHOU, Huifang, Wuhan, Hubei 430205 (CN); ZHANG, Zhongjie, Wuhan, Hubei 430205 (CN)
(74) Representative: Lorenz & Kollegen
(86) International application number: PCT/CN2024/111936
(87) International publication number: WO 2026/020519

(57) **Abstract**

A display panel (100) and a display device, which relate to the technical field of display, and are used for improving the wide-viewing-angle privacy protection effect of the display panel. The display panel (100) comprises: a substrate (1); a plurality of light-emitting elements located on one side of the substrate (1), wherein the light-emitting elements comprise first light-emitting elements (21), each first light-emitting element (21) comprising a first light-emitting portion (211) and a second light-emitting portion (212); a pixel definition layer (3), which is located on one side of the substrate (1), the pixel definition layer (3) comprising first openings and second openings, wherein the first light-emitting portions (211) are at least partially located in the first openings, and the second light-emitting portions (212) are at least partially located in the second openings; and a touch control layer (4), which is located on the sides of the light-emitting elements away from the substrate (1), the touch control layer (4) comprising first touch control sub-portions (41) and third openings, wherein in a direction perpendicular to the plane where the substrate is located, the first touch control sub-portions (41) at least partially overlap with the first openings, and the third openings at least partially overlap with the second openings.

## Description

### CROSS-REFERENCE TO RELATED APPLICATIONS

The present application claims priority to Chinese Application No. 202410997757.6 with the application title of "DISPLAY PANEL AND DISPLAY APPARATUS", filed on July 23, 2024, the content of which is incorporated herein by reference in its entirety.

### TECHNICAL FIELD

The present invention relates to the field of display technologies, and particularly, to a display panel and a display apparatus.

### BACKGROUND

With the continuous development of display technologies, consumers' requirements for display screens are constantly increasing. At present, various types of display screens, including liquid crystal display screens and organic light-emitting display screens, have emerged in an endless stream and achieved rapid development. On this ground, display technologies such as 3D display, touch display, curved display, ultra-high resolution display and anti-peeping display have been constantly emerging.

Currently, the improvement of the anti-peeping performance of active light-emitting display screens, including organic light-emitting elements (OLED), has attracted great attention from researchers.

### SUMMARY

An aspect of the present invention provides a display panel. The display panel includes: a substrate, a pixel definition layer, and a touch layer. The substrate includes a display region. The display region includes a plurality of light-emitting elements located on a side of the substrate, and the plurality of light-emitting elements includes a first light-emitting element, the first light-emitting element includes a first light-emitting portion and a second light-emitting portion. The pixel definition layer is located on a side of the substrate. The pixel definition layer includes a first opening and a second opening. At least part of the first light-emitting portion is located within the first opening, and at least part of the second light-emitting portion is located within the second opening. A touch layer is located on a side of the light-emitting elements facing away from the substrate. The touch layer includes a first touch sub-portion and a third opening, along a direction perpendicular to a plane of the substrate, the first touch sub-portion at least partially overlaps the first opening, and the third opening at least partially overlaps the second opening.

Another aspect of the present invention provides a display apparatus. The display apparatus includes a display panel. The display panel includes: a substrate, a pixel definition layer, and a touch layer. The substrate includes a display region. The display region includes a plurality of light-emitting elements located on a side of the substrate, and the plurality of light-emitting elements includes a first light-emitting element, the first light-emitting element includes a first light-emitting portion and a second light-emitting portion. The pixel definition layer is located on a side of the substrate. The pixel definition layer includes a first opening and a second opening. At least part of the first light-emitting portion is located within the first opening, and at least part of the second light-emitting portion is located within the second opening. A touch layer is located on a side of the light-emitting elements facing away from the substrate. The touch layer includes a first touch sub-portion and a third opening, along a direction perpendicular to a plane of the substrate, the first touch sub-portion at least partially overlaps the first opening, and the third opening at least partially overlaps the second opening.

### BRIEF DESCRIPTION OF DRAWINGS

In order to explain the embodiments of the present invention or the technical solution in the related art more clearly, the drawings to be used in the description of the embodiments or the related art will be briefly described below. The drawings in the following description are some embodiments of the present invention. For those skilled in the art, other drawings may further be obtained based on these drawings.
FIG. 1 is a top view of a display panel according to some embodiments of the present invention;
FIG. 2 is a cross-sectional view of FIG. 1 along BB' according to some embodiments of the present invention;
FIG. 3 is a schematic diagram of a touch display panel according to some embodiments of the present invention;
FIG. 4 is a schematic diagram of a display apparatus for fingerprint recognition according to some embodiments of the present invention;
FIG. 5 is a top view of a touch layer in FIG. 1 according to some embodiments of the present invention;
FIG. 6 is a top view of another display panel according to some embodiments of the present invention;
FIG. 7a is a schematic diagram of a first pixel driving circuit for driving a first light-emitting portion according to some embodiments of the present invention;
FIG. 7b is a working timing diagram of a first pixel driving circuit according to some embodiments of the present invention;
FIG. 7c is a working timing diagram of another first pixel driving circuit according to some embodiments of the present invention;
FIG. 8a is a schematic diagram of a second pixel driving circuit according to some embodiments of the present invention;
FIG. 8b is a working timing diagram of a second pixel driving circuit according to some embodiments of the present invention;
FIG. 9 is a schematic diagram of a positional relationship between a first touch sub-portion and a first opening according to some embodiments of the present invention;
FIG. 10 is a schematic diagram of another positional relationship between a first touch sub-portion and a first opening according to some embodiments of the present invention;
FIG. 11 is a schematic diagram of a positional relationship between a third opening and a second opening according to some embodiments of the present invention;
FIG. 12 is a schematic diagram of another positional relationship between a third opening and a second opening according to some embodiments of the present invention;
FIG. 13 is a cross-sectional view of another display panel according to some embodiments of the present invention;
FIG. 14 is a top view of a first light-dimming portion, a first touch sub-portion, and a first light-emitting portion according to some embodiments of the present invention;
FIG. 15 is a cross-sectional view of another display panel according to some embodiments of the present invention;
FIG. 16 is a top view of a first light-dimming portion, a first touch sub-portion, and a first light-emitting portion according to some embodiments of the present invention;
FIG. 17 is a top view of a third light-dimming portion, the second touch sub-portion, and the second light-emitting portion according to some embodiments of the present invention;
FIG. 18 is a cross-sectional view of another display panel according to some embodiments of the present invention;
FIG. 19 is a top view of third light-dimming portion, the second touch sub-portion, and the second light-emitting portion according to some embodiments of the present invention;
FIG. 20 is a top view of another display panel according to some embodiments of the present invention;
FIG. 21 is a schematic diagram of the positional relationship between a display panel and a windshield according to some embodiments of the present invention; and
FIG. 22 is a structural schematic diagram of a display apparatus according to some embodiments of the present invention.

### DESCRIPTION OF EMBODIMENTS

In order to better understand technical solutions of the present invention, the embodiments of the present invention are described in details with reference to the drawings.

It should be clear that the described embodiments are merely part of the embodiments of the present invention rather than all of the embodiments. All other embodiments obtained by those skilled in the art without paying creative labor shall fall into the protection scope of the present invention.

The terms used in the embodiments of the present invention are merely for the purpose of describing specific embodiment, rather than limiting the present invention. The terms "a", "an", "the" and "said" in a singular form in the embodiment of the present invention and the attached claims are also intended to include plural forms thereof, unless noted otherwise.

It should be understood that the term "and/or" used in the context of the present invention is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

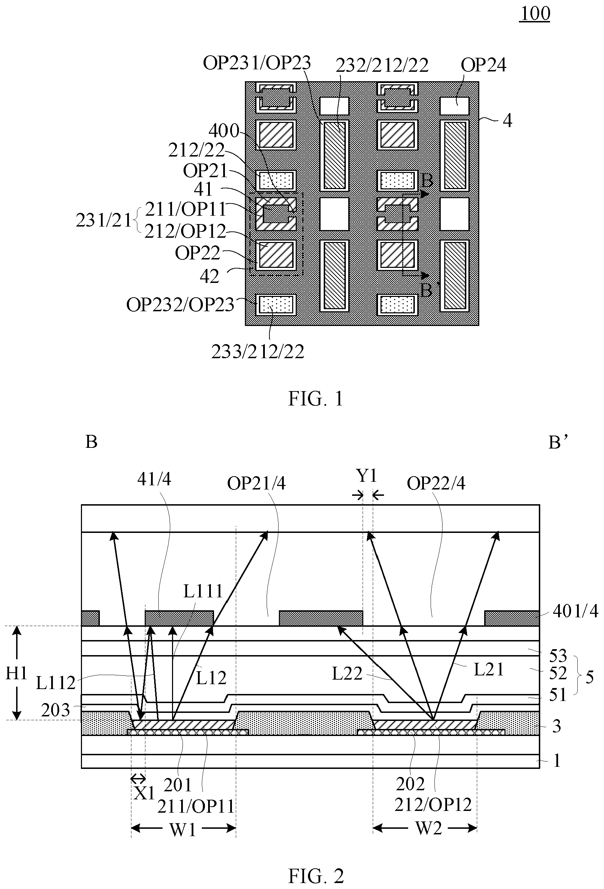

Embodiments of the present invention provide a display panel. FIG. 1 is a top view of a display panel according to some embodiments of the present invention, and FIG. 2 is a cross-sectional view of FIG. 1 along BB'. As shown in FIG. 1 and FIG. 2, the display panel 100 includes a substrate 1 and a plurality of light-emitting elements on one side of the substrate 1. The light-emitting elements includes a first light-emitting element 21, and the first light-emitting element 21 includes a first light-emitting portion 211 and a second light-emitting portion 212. The first light-emitting portion 211 and the second light-emitting portion 212 are capable of emitting light of a predetermined color. In some embodiments of the present invention, the first light-emitting portion 211 and the second light-emitting portion 212 include any one of organic light-emitting materials, quantum dot light-emitting materials, and inorganic light-emitting materials. The embodiments of the present invention do not limit the materials of the first light-emitting portion 211 and the second light-emitting portion 212.

In some embodiments of the present invention, as shown in FIG. 1 and FIG. 2, the first light-emitting portion 211 and the second light-emitting portion 212 are arranged adjacent to each other. Adjacent arrangement means that there is no other light-emitting portion between the first light-emitting portion 211 and the second light-emitting portion 212.

As shown in FIG. 2, the display panel 100 further includes a pixel definition layer 3. The pixel definition layer 3 is located on a side of the substrate 1. The pixel definition layer 3 includes a first opening OP11 and a second opening OP12. At least part of the first light-emitting portion 211 is located within the first opening OP11, and at least part of the second light-emitting portion 212 is located within the second opening OP12.

In some embodiments of the present invention, as shown in FIG. 2, the display panel 100 further includes a first electrode 201, a second electrode 202, and a third electrode 203. The first electrode 201 and the second electrode 202 are located on a side of the pixel definition layer 3 adjacent to the substrate 1. The first opening OP11 exposes at least part of the first electrode 201, and the second opening OP12 exposes at least part of the second electrode 202. The first electrode 201 and the second electrode 202 are arranged at intervals. The third electrode 203 is located on a side of the first light-emitting portion 211 and the second light-emitting portion 212 facing away from the substrate 1. In some embodiments of the present invention, the first electrode 201 and the second electrode 202 can serve as anodes, and the third electrode 203 can serve as a cathode. An orthographic projection of the third electrode 203 on the plane of the substrate 1 covers the first light-emitting portion 211 and the second light-emitting portion 212. That is, the third electrode 203 can be formed into an integral layer structure covering a plurality of light-emitting portions.

In some embodiments of the present invention, display modes of the display panel 100 according to the embodiments of the present invention includes an anti-peeping mode and a public mode.

In the anti-peeping mode, both the first light-emitting portion 211 and the second light-emitting portion 212 emit light. For users at a large viewing angle, the large-angle light emitted by the first light-emitting portion 211 may interfere with the large-angle light emitted by the second light-emitting portion 212, so that the information displayed on the display panel 100 is blurred or disordered at a large viewing angle. That is, it can make it impossible for a user at a large viewing angle to clearly view the display screen of the display panel, thus achieving the large-angle anti-peeping effect. Here, large-angle light refers to the light whose propagation direction makes a large angle with the normal direction of the substrate 1. The viewing angle refers to the angle between the sight direction and the normal direction of the substrate 1.

In the public mode, the first light-emitting portion 211 does not emit light, and the second light-emitting portion 212 emits light. For a user at the normal viewing angle, the small-angle light emitted by the second light-emitting portion 212 can enter the user's eyes, allowing the user to view the display screen of the display panel 100. For users at a large viewing angle, the large-angle light emitted by the second light-emitting portion 212 can enter the users' eyes, allowing the users to still view the display screen of the display panel 100 at a large viewing angle. Here, small-angle light refers to the light whose propagation direction makes a small angle with the normal direction of the substrate 1.

As shown in FIG. 1 and FIG. 2, the display panel 100 further includes a touch layer 4. The touch layer 4 is located on a side of the light-emitting elements facing away from the substrate 1. The touch layer 4 includes a first touch sub-portion 41 and a third opening OP22. In some embodiments of the present invention, the first touch sub-portion 41 may transmit touch signals.

In some embodiments of the present invention, the display panel 100 may adopt self-capacitance touch.

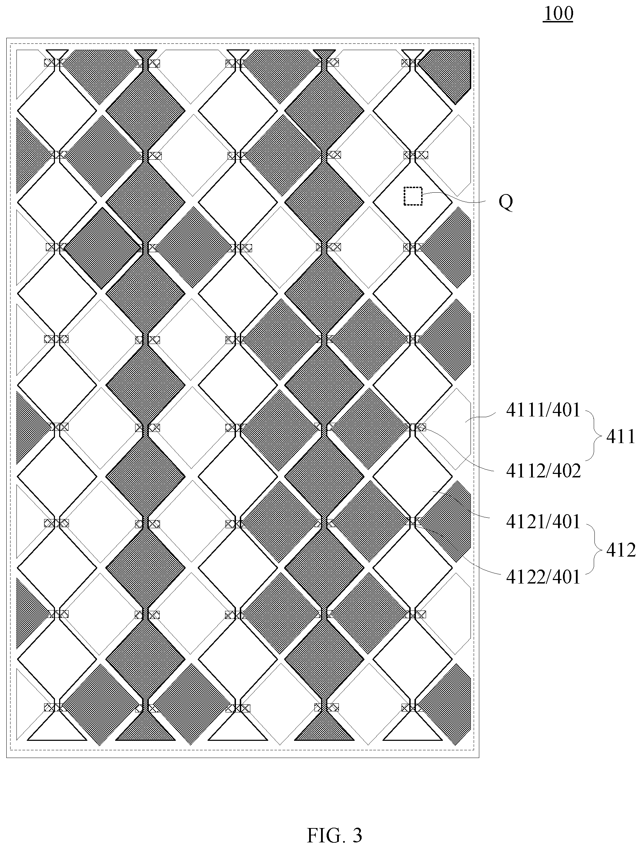

In some embodiments of the present invention, the display panel 100 may also adopt mutual-capacitance touch. As shown in FIG. 3, where FIG. 3 is a schematic diagram of a touch display panel according to some embodiments of the present invention, the display panel 100 includes a first touch electrode 411 and a second touch electrode 412. One of the first touch electrode 411 and the second touch electrode 412 serves as a touch driving electrode, and the other serves as a touch sensing electrode. The touch driving electrode is used to transmit touch driving signals, and the touch sensing electrode is used to transmit touch sensing signals. In this case, the above-mentioned first touch sub-portion 41 may participate in the touch operation as part of the first touch electrode 411. In some embodiments of the present invention, the first touch sub-portion 41 may also participate in the touch operation as part of the second touch electrode 412. In other words, the first touch sub-portion 41 may transmit touch driving signals or touch sensing signals. FIG. 1 can be regarded as an enlarged schematic diagram of a region Q in FIG. 3.

In some embodiments of the present invention, as shown in FIG. 3, the first touch electrode 411 includes a first main touch electrode 4111 and a first connecting electrode 4112 that are electrically connected. The second touch electrode 412 includes a second main touch electrode 4121 and a second connecting electrode 4122 that are electrically connected.

In some embodiments of the present invention, as shown in FIG. 3, the display panel 100 includes a first conductive layer 401 and a second conductive layer 402, as well as a touch insulating layer (not shown in FIG. 3) located therebetween. In some embodiments of the present invention, the first main touch electrode 4111, the second main touch electrode 4121, and the second connecting electrode 4122 may be arranged on the same layer and in the first conductive layer 401, and the first connecting electrode 4112 may be arranged in the second conductive layer 402.

In some embodiments of the present invention, the touch layer 4 includes the above-mentioned first conductive layer 401 and/or the second conductive layer 402. That is, in the embodiments of the present invention, the above-mentioned first touch sub-portion 41 and the third opening OP22 may be arranged in at least one of the first conductive layer 401 and the second conductive layer 402. FIG. 2 takes the arrangement of the above-mentioned first touch sub-portion 41 and the third opening OP22 in the first conductive layer 401 as an example. In some embodiments of the present invention, as shown in FIG. 2, the third opening OP22 may penetrate the first conductive layer 401. In some embodiments of the present invention, the first touch sub-portion 41 and the third opening OP22 may be located in the above-mentioned first main touch electrode 4111, or they may also be located in the second main touch electrode 4121.

As shown in FIG. 2, along a direction perpendicular to the plane of the substrate 1, the first touch sub-portion 41 at least partially overlaps the first opening OP11. When the first light-emitting portion 211 is turned on to emit light, some small-angle light L111 emitted by the first light-emitting portion 211 can be blocked by the first touch sub-portion 41, thus preventing these light from exiting from the display panel 100. Moreover, in the embodiments of the present invention, the first touch sub-portion 41 has a high reflectivity, and the first touch sub-portion 41 can act as a reflective layer to reflect some small-angle incident light L112 at least one time, the reflected light can avoid the first touch sub-portion 41 and exit from the display panel 100. This can improve the light utilization rate of the first light-emitting portion 211, enhance the light intensity of the large-angle light exiting from the display panel 100, interfere with the light emitted by the second light-emitting portion 212 to a greater extent at a large viewing angle by using the light emitted by the first light-emitting portion 211, thereby reducing the readability of the display panel 100 at a large viewing angle outside the visible viewing angle, improving the large-angle anti-peeping effect of the display panel 100, and further reducing the power consumption of the display panel 100.

Furthermore, based on this arrangement, it is equivalent to reusing the first touch sub-portion 41 as a light-dimming component for adjusting the light emitted by the first light-emitting portion 211. Thus, there is no need to add additional components to adjust the light emitted by the first light-emitting portion 211. This is beneficial to simplifying the structure of the display panel 100, reducing the manufacturing process of the display panel 100 and the cost of the display panel 100.

In addition, in the embodiments of the present invention, the first touch sub-portion 41 may be used to transmit touch signals, making the first touch sub-portion 41 as part of the touch electrode. In this case, the arrangement of the first touch sub-portion 41 can increase the area of the touch electrode, thereby reducing the impedance of the touch electrode. When performing touch operations on the display panel 100, it is beneficial to improve the touch sensitivity and enhance the touch experience of the display panel 100.

As shown in FIG. 1 and FIG. 2, along the direction perpendicular to the plane of the substrate 1, the third opening OP22 and the second opening OP12 at least partially overlap. When the second light-emitting portion 212 is turned on to emit light, as shown in FIG. 2, at least some small-angle light L21 emitted by the second light-emitting portion 212 can exit through the third opening OP22. Thus, the small-angle light L21 emitted by the second light-emitting portion 212 can be prevented from being blocked by the touch layer 4, which is beneficial to improving the display effect of the display panel 100 at the normal viewing angle.

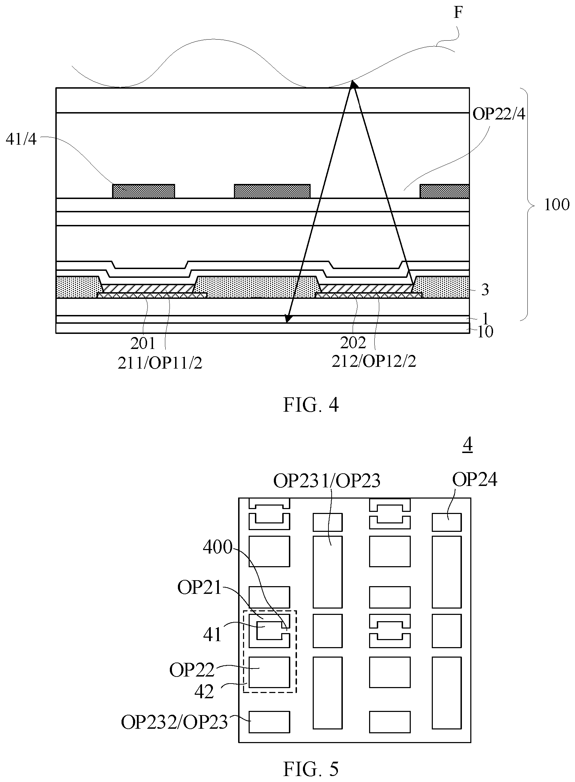

In addition, the arrangement of the third opening OP22 can increase the light transmittance of the touch layer 4, thereby increasing the light transmittance of the display panel 100. When the display panel 100 is used in a display apparatus equipped with optical components such as fingerprint sensors, cameras, and iris sensors, it can enhance the light intensity received by the optical components and improve the working performance of the optical components. FIG. 4 is a schematic diagram of a display apparatus for fingerprint recognition according to some embodiments of the present invention. Taking the display apparatus with fingerprint recognition function as an example, as shown in FIG. 4, when performing fingerprint recognition on the display apparatus, the light emitted by the fingerprint recognition light source, such as the light-emitting element 2, is reflected by the finger F pressing on the light-emitting surface of the display apparatus, and at least some reflected light can be directed to the fingerprint sensor 10 through the third opening OP22. In some embodiments of the present invention, the fingerprint sensor 10 may be located on a side of the pixel definition layer 3 facing away from the touch layer 4. For example, the fingerprint sensor 10 may be arranged on a side of the substrate 1 facing away from the pixel definition layer 3. Based on this arrangement, the light intensity of the finger-reflected light received by the fingerprint sensor 10 can be increased, which is beneficial to improving the sensitivity and accuracy of fingerprint recognition.

FIG. 5 is a top view of a touch layer in FIG. 1. In some embodiments of the present invention, as shown in FIG. 1, FIG. 2 and FIG. 5, the touch layer 4 further includes a fourth opening OP21 and a second touch sub-portion 42. The second touch sub-portion 42 at least partially surrounds the above-mentioned third opening OP22. An orthographic projection of the fourth opening OP21 on the plane of the substrate 1 covers the above-mentioned first opening (not shown in FIG. 5). The arrangement of the fourth opening OP21 can further increase the light transmittance of the touch layer 4, thereby increasing the light transmittance of the display panel 100.

In some embodiments of the present invention, as shown in FIG. 1, FIG. 2 and FIG. 5, the first touch sub-portion 41 is located within the fourth opening OP21.

In some embodiments of the present invention, as shown in FIG. 1 and FIG. 5, the first touch sub-portion 41 can be electrically connected to the non-opening part of the touch layer 4 through a connecting portion 400. In some embodiments of the present invention, the first touch sub-portion 41 may be electrically connected to the non-opening part of the touch layer 4 through one or more connecting portions 400. The embodiments of the present invention do not limit the number of the connecting portions 400.

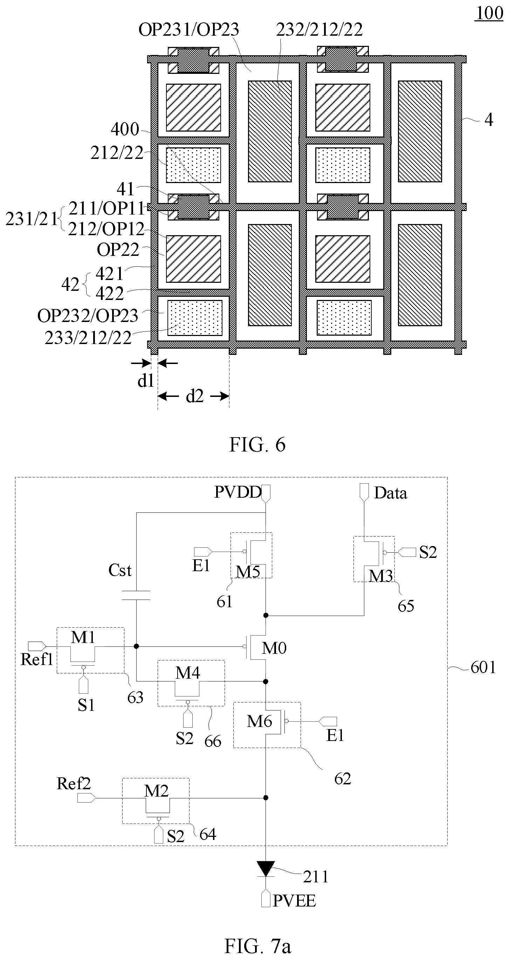

In some embodiments of the present invention, as shown in FIG. 6, where FIG. 6 is a top view of another display panel according to some embodiments of the present invention, a width d1 of the second touch sub-portion 42 may be made smaller than a width d2 of the third opening OP22 to further increase the light-transmitting area of the touch layer 4, thereby increasing the light transmittance of the touch layer 4. Here, the width direction of the third opening OP22 is parallel to the width direction of the second touch sub-portion 42, and the width direction of the second touch sub-portion 42 is perpendicular to its extending direction.

In some embodiments of the present invention, as shown in FIG. 6, the second touch sub-portion 42 includes a first part 421 and a second part 422 whose extending directions intersect. The first part 421 and the second part 422 intersect each other to define the above-mentioned third opening OP22. In some embodiments of the present invention, the widths of the first part 421 and the second part 422 may both be smaller than the width of the third opening OP22.

In some embodiments of the present invention, as shown in FIG. 6, the first touch sub-portion 41 may be connected to the second touch sub-portion 42.

In some embodiments of the present invention, the touch layer 4 includes metals or transparent metal oxides. Metals include alloys composed of any one or more of molybdenum (Mo), aluminum (Al), copper (Cu), and titanium (Ti). Transparent metal oxides include indium tin oxide (ITO), indium zinc oxide (IZO), zinc oxide (ZnO), and indium zinc tin oxide (IZTO).

In some embodiments of the present invention, the touch layer 4 includes a single-layer structure or a multi-layer structure arranged in a stacking manner. For example, in some embodiments of the present invention, the touch layer 4 may be set as a three-layer structure including a titanium layer, an aluminum layer, and a titanium layer arranged in a stacking manner.

In some embodiments of the present invention, as shown in FIG. 2, the display panel 100 further includes a encapsulation layer 5, and the above-mentioned touch layer 4 is located on a side of the encapsulation layer 5 facing away from the substrate 1. In some embodiments of the present invention, the encapsulation layer 5 includes a first inorganic encapsulation layer 51, an organic encapsulation layer 52, and a second inorganic encapsulation layer 53 arranged in a stacking manner.

In some embodiments of the present invention, the first light-emitting portion 211 and the second light-emitting portion 212 may be driven separately. In some embodiments of the present invention, as shown in FIG. 7a, where FIG. 7a is a schematic diagram of a first pixel driving circuit for driving a first light-emitting portion according to some embodiments of the present invention, the display panel 100 further includes a first pixel driving circuit 601, and the first pixel driving circuit 601 includes a first light-emitting control module 61, a second light-emitting control module 62, a gate reset module 63, an anode reset module 64, a data writing module 65, a threshold compensation module 66, and a storage capacitor Cst.

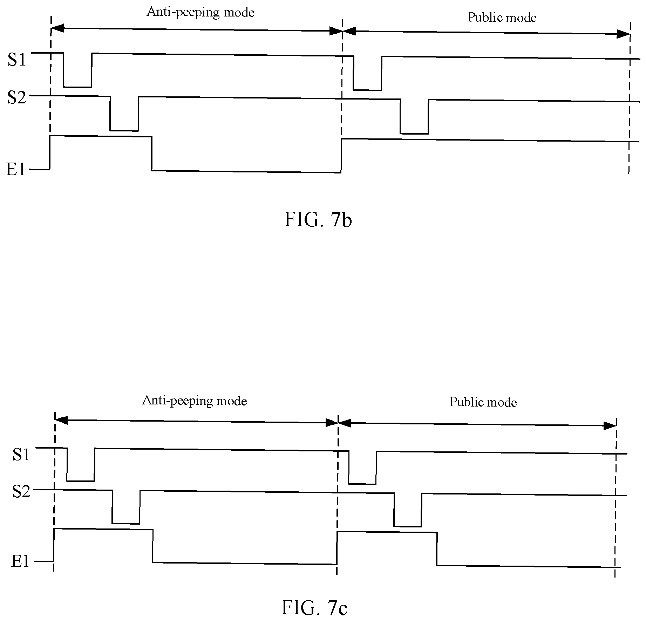

Combined with FIG. 7a and FIG. 7b, where FIG. 7b is a working timing diagram of a first pixel driving circuit according to some embodiments of the present invention, the gate reset module 63 includes a gate reset transistor M1, the gate reset transistor M1 is electrically connected between the first reset signal line Ref1 and the gate of the driving transistor M0, and is configured to reset the gate of the driving transistor M0 in response to the effective level provided by the first scanning signal line S1. The anode reset module 64 includes an anode reset transistor M2, the anode reset transistor M2 is electrically connected between the second reset signal line Ref2 and the second light-emitting portion 212, and is configured to reset the anode voltage of the second light-emitting portion 212 in response to the effective level provided by the second scanning signal line S2. The data writing module 65 includes a data writing transistor M3, the data writing transistor M3 is electrically connected between the data line Data and a first pole of the driving transistor M0. The threshold compensation module 66 includes a threshold compensation transistor M4, and the threshold compensation transistor M4 is electrically connected between a second pole of the driving transistor M0 and the gate of the driving transistor M0. The data writing transistor M3 and the threshold compensation transistor M4 are configured to write the data voltage into the gate of the driving transistor M0 and perform threshold compensation on the driving transistor M0 in response to the effective level provided by the second scanning signal line S2.

The first light-emitting control module 61 includes a first light-emitting control transistor M5, and the first light-emitting control transistor M5 is electrically connected between the power supply signal line PVDD and the first pole of the driving transistor M0. The second light-emitting control module 62 includes a second light-emitting control transistor M6, and the second light-emitting control transistor M6 is electrically connected between the second pole of the driving transistor M0 and the first light-emitting portion 211.

In some embodiments of the present invention, in the anti-peeping mode, as shown in FIG. 7b, the first pixel driving circuit 601 transmits the driving current converted by the driving transistor M0 to the first light-emitting portion 211, in response to the enable level provided by the first light-emitting control signal line E1, so as to drive the first light-emitting portion 211 to emit light.

In the public mode, as shown in FIG. 7b, the first pixel driving circuit 601 controls the transmission path between the first pixel driving circuit 601 and the first light-emitting portion 211 to be turned off, in response to the non-enable level provided by the first light-emitting control signal line E1, so that the first light-emitting portion 211 does not emit light, thereby reducing the power consumption of the display panel 100. In some embodiments of the present invention, as shown in FIG. 7c, where FIG. 7c is a working timing diagram of a first pixel driving circuit according to some embodiments of the present invention, the first light-emitting control signal line E1 may also transmit the enable level in the public mode. In this case, the data line Data may transmit a data voltage that makes the driving current 0, so that the first light-emitting portion 211 does not emit light.

When driving the second light-emitting portion 212, In some embodiments of the present invention, the same structure as the first pixel driving circuit 601 shown in FIG. 7a may be adopted, or a structure different from the first pixel driving circuit 601 shown in FIG. 7a may be adopted.

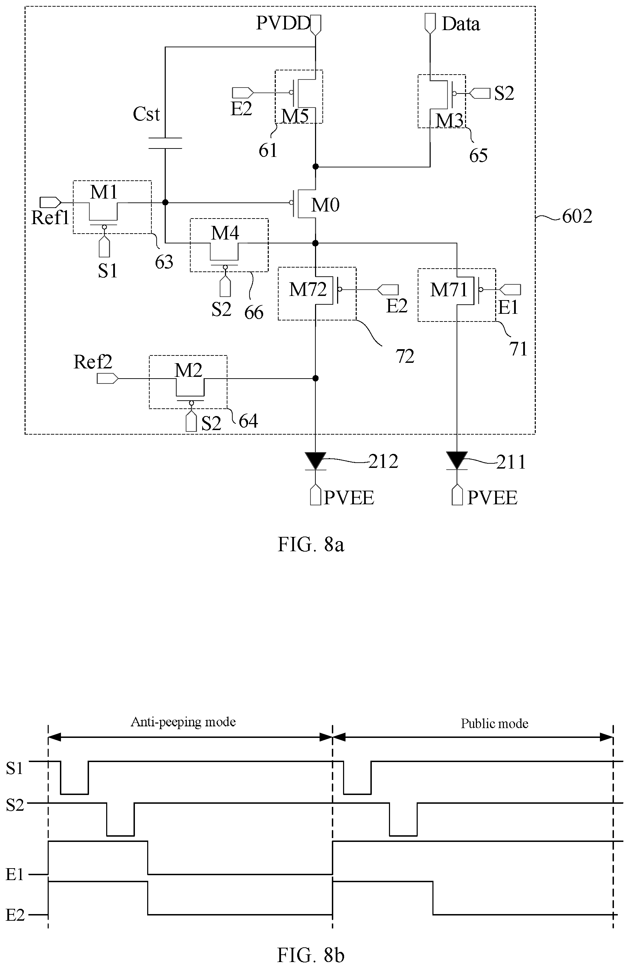

In some embodiments of the present invention, as shown in FIG. 8a, where FIG. 8a is a schematic diagram of a second pixel driving circuit according to some embodiments of the present invention, the second pixel driving circuit 602 includes a driving transistor M0, a third light-emitting control module 71, and a fourth light-emitting control module 72. The third light-emitting control module 71 is electrically connected between the driving transistor M0 and the first light-emitting portion 211, and the fourth light-emitting control module 72 is electrically connected between the driving transistor M0 and the second light-emitting portion 212.

In the anti-peeping mode, both the third light-emitting control module 71 and the fourth light-emitting control module 72 are turned on, so that both the first light-emitting portion 211 and the second light-emitting portion 212 emit light. The large-angle light emitted by the first light-emitting portion 211 interfere with the large-angle light emitted by the second light-emitting portion 212, thus blurring the image at a large viewing angle and achieving the large-angle anti-peeping effect of the display panel 100.

In the public mode, the third light-emitting control module 71 is turned off, so that the first light-emitting portion 211 does not emit light, and the fourth light-emitting control module 72 is turned on, so that the second light-emitting portion 212 emits light.

In some embodiments of the present invention, the second pixel driving circuit 602 further includes a gate reset module 63, an anode reset module 64, a data writing module 65, a threshold compensation module 66, a first light-emitting control module 61, and a storage capacitor Cst. The specific structures and connection relationships of the gate reset module 63, the anode reset module 64, the data writing module 65, the threshold compensation module 66, the first light-emitting control module 61, and the storage capacitor Cst may be the same as the corresponding structures in the first pixel driving circuit 601 shown in FIG. 7a. The embodiments of the present invention will not elaborate on this here.

As shown in FIG. 8a, the third light-emitting control module 71 includes a third light-emitting control transistor M71, and the third light-emitting control transistor M71 is configured to transmit the driving current converted by the driving transistor M0 to the first light-emitting portion 211 in response to the enable level provided by the first light-emitting control signal line E1, so as to drive the first light-emitting portion 211 to emit light.

The fourth light-emitting control module 72 includes a fourth light-emitting control transistor M72, and the fourth light-emitting control transistor M72 is configured to transmit the driving current converted by the driving transistor M0 to the second light-emitting portion 212 in response to the enable level provided by the second light-emitting control signal line E2, so as to drive the second light-emitting portion 212 to emit light.

In some embodiments, in the anti-peeping mode, as shown in combination with FIG. 8b, where FIG. 8b is a working timing diagram of a second pixel driving circuit according to some embodiments of the present invention, the second pixel driving circuit 602 transmits the driving current converted by the driving transistor M0 to the first light-emitting portion 211 in response to the enable level provided by the first light-emitting control signal line E1, so as to drive the first light-emitting portion 211 to emit light. In addition, the second pixel driving circuit 602 transmits the driving current converted by the driving transistor M0 to the second light-emitting portion 212 in response to the enable level provided by the second light-emitting control signal line E2, so as to drive the second light-emitting portion 212 to emit light.

In the public mode, as shown in combination with FIG. 8b, the second pixel driving circuit 602 controls the transmission path between the second pixel driving circuit 602 and the first light-emitting portion 211 to be turned off in response to the non-enable level provided by the first light-emitting control signal line E1, so that the first light-emitting portion 211 does not emit light. In addition, the second pixel driving circuit 602 transmits the driving current converted by the driving transistor M0 to the second light-emitting portion 212 in response to the enable level provided by the second light-emitting control signal line E2, so as to drive the second light-emitting portion 212 to emit light.

Based on the above structure, in the anti-peeping mode, the first light-emitting portion 211 and the second light-emitting portion 212 can share the driving current provided by the same second pixel driving circuit 602 to emit light. There is no need to arrange an additional circuit structure for the first light-emitting portion 211 to provide driving current. This simplifies the circuit design of the display panel 100 and reduces the occupied space of the pixel driving circuit in the display panel 100, which is beneficial to increasing the pixel density.

In some embodiments of the present invention, in the anti-peeping mode, the brightness of the first light-emitting portion 211 may be greater than or equal to that of the second light-emitting portion 212, so as to increase the brightness of the large-angle light emitted by the first light-emitting portion 211, enhance the interference effect of the light emitted by the first light-emitting portion 211, and improve the large-angle anti-peeping effect of the display panel 100.

In some embodiments of the present invention, the light-emitting colors of the first light-emitting portion 211 and the second light-emitting portion 212 may be the same or different, so as to enhance the interference effect of the light emitted by the first light-emitting portion 211 on the light of the second light-emitting portion 212 and improve the large-angle anti-peeping effect of the display panel 100.

In some embodiments of the present invention, as shown in FIG. 1 and FIG. 6, the light-emitting elements further includes a second light-emitting element 22. The second light-emitting element 22 is only provided with a second light-emitting portion 212. That is to say, the second light-emitting element 22 does not have a first light-emitting portion for anti-peeping. With such an arrangement, while improving the large-angle anti-peeping effect of the display panel 100, it is possible to avoid providing too many first light-emitting portions for anti-peeping in the display panel 100. This can reduce the occupied area of the first light-emitting portions, which is beneficial to providing more second light-emitting portions 212 in the display panel 100 and improving the resolution of the display panel 100.

In some embodiments of the present invention, the colors of the second light-emitting portion 212 in the first light-emitting element 21 and the second light-emitting portion 212 in the second light-emitting element 22 may be different.

As shown in FIG. 1 and FIG. 6, the display panel 100 includes a first-color light-emitting element 231, a second-color light-emitting element 232, and a third-color light-emitting element 233. The first-color light-emitting element 231 is configured to emit light of the first color, the second-color light-emitting element 232 is configured to emit light of the second color, and the third-color light-emitting element is configured to emit light of the third color. The first color, the second color, and the third color are different from each other, so that the display panel can achieve full-color display. In some embodiments of the present invention, the first color, the second color, and the third color may be green, blue, and red respectively.

In some embodiments of the present invention, the first light-emitting element 21 includes the first-color light-emitting element 231, and the second light-emitting element 22 includes the second-color light-emitting element 232 and/or the third-color light-emitting element 233. In some embodiments of the present invention, the first-color light-emitting element 231 includes a green light-emitting element, the second-color light-emitting element 232 includes a blue light-emitting element, and the third-color light-emitting element 233 includes a red light-emitting element. Compared with the red light-emitting element and the blue light-emitting element, the green light-emitting element has a higher light-emitting efficiency. With such an arrangement, under the condition of providing fewer first light-emitting portions, the light intensity of the large-angle light emitted by the first light-emitting portion can be enhanced, which is beneficial to improving the large-angle anti-peeping effect of the display panel 100.

It should be noted that the shapes of the various light-emitting elements and the arrangement rules among different light-emitting elements shown in FIG. 1 and FIG. 6 are only for illustration. Those skilled in the art can adjust the shapes of the light-emitting elements and the arrangement rules among different light-emitting elements according to different design requirements. The embodiments of the present invention do not limit this.

In some embodiments of the present invention, as shown in FIG. 1 and FIG. 6, the touch layer 4 further includes a fifth opening OP23, the fifth opening OP23 at least partially exposes the second light-emitting portion 212 in the second light-emitting element 22, so that the light emitted by the second light-emitting element 22 can exit through the fifth opening OP23, ensuring the light intensity of the light emitted by the second light-emitting element 22. In addition, the fifth opening OP23 can further increase the light transmittance of the touch layer 4, thereby further increasing the light transmittance of the display panel 100.

In some embodiments of the present invention, as shown in FIG. 1 and FIG. 6, the fifth opening OP23 includes a first sub-opening OP231 and a second sub-opening OP232. Along the direction perpendicular to the plane of the substrate 1, the first sub-opening OP231 at least partially overlaps the above-mentioned second-color light-emitting element 232, and the second sub-opening OP232 at least partially overlaps the above-mentioned third-color light-emitting element 233. The light emitted by the second-color light-emitting element 232 can exit through the first sub-opening OP231, and the light emitted by the third-color light-emitting element 233 can exit through the second sub-opening OP232.

In some embodiments of the present invention, as shown in FIG. 1 and FIG. 5, the touch layer 4 further includes at least one sixth opening OP24. Along the direction perpendicular to the plane of the substrate 1, the sixth opening OP24 does not overlap the above-mentioned first light-emitting element (not shown in FIG. 5) and the second light-emitting element (not shown in FIG. 5). The arrangement of the sixth opening OP24 can further increase the light transmittance of the touch layer 4, which is beneficial to increasing the light transmittance of the display panel 100.

In some embodiments, when providing the first touch sub-portion 41 and the first opening OP11, as shown in FIG. 1 and FIG. 2, an area of the orthographic projection of the first touch sub-portion 41 on the plane of the substrate 1 may be made less than or equal to an area of the orthographic projection of the first opening OP11 on the plane of the substrate 1. For example, the orthographic projection of the first opening OP11 on the plane of the substrate 1 can be made to cover the orthographic projection of the first touch sub-portion 41 on the plane of the substrate 1, so as to avoid the first touch sub-portion 41 from excessively blocking the large-angle light emitted by the first light-emitting portion 211, increasing the intensity of the large-angle light emitted by the first light-emitting portion 211, and improving the large-angle anti-peeping effect of the display panel 100.

In some embodiments of the present invention, as shown in FIG. 2, the orthographic projection of the first touch sub-portion 41 on the plane of the substrate 1 is located within the first opening OP11. Along the direction parallel to the plane of the substrate 1, a distance between an edge of the first touch sub-portion 41 and an edge of the first opening OP11 closest to it is X1, and a width of the first opening OP11 is W1. In some embodiments of the present invention, as shown in FIG. 2, the width of the first opening OP11 on the side facing away from the substrate 1 may be greater than the that on the side adjacent to the substrate 1. That is, the side surface of the first opening OP11 and the plane of the substrate 1 may be set as an inclined structure with an acute angle. The above-mentioned width W1 of the first opening OP11 may be the width of the first opening OP11 on the side facing away from the substrate 1.

Along the direction perpendicular to the plane of the substrate 1, a distance between the first touch sub-portion 41 and the first light-emitting portion 211 is H1. In some embodiments of the present invention, the distance H1 between the first touch sub-portion 41 and the first light-emitting portion 211 may be the distance between the surface of the first touch sub-portion 41 adjacent to the substrate 1 and the first light-emitting portion 211. That is, the distance H1 between the first touch sub-portion 41 and the first light-emitting portion 211 may be the film thickness of the film layers between the first touch sub-portion 41 and the first light-emitting portion 211. As shown in FIG. 2, at least the encapsulation layer 5 and the third electrode 203 may be included between the first touch sub-portion 41 and the first light-emitting portion 211. In some embodiments, 0 ≤ X1 ≤ W1 - H1×k1, and k1 is a constant.

In the embodiments of the present invention, k1 may be adjusted accordingly according to different requirements for the anti-peeping viewing angle. The anti-peeping viewing angle refers to the viewing angle at which the display screen cannot be clearly seen. For example, when the anti-peeping viewing angle is 45°, it means that a user viewing the display panel 100 at an angle greater than or equal to 45° cannot clearly see the display image of the display panel 100.

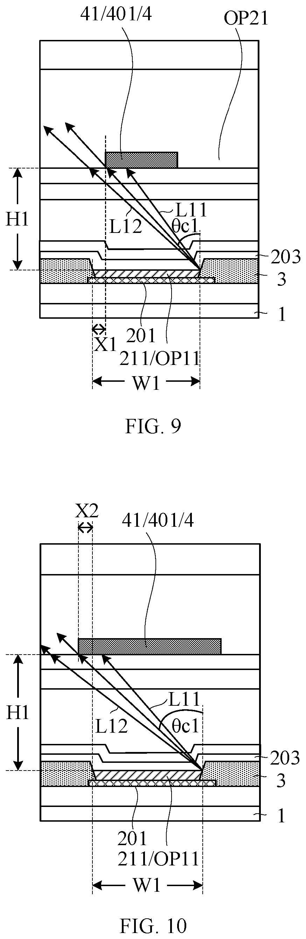

In some embodiments of the present invention, when the anti-peeping viewing angle is set to 45°, k1 may be set to be equal to tan45°. Based on the above arrangement provided by the embodiments of the present invention, 0 < X1 ≤ W1 - H1 × tan45°may be obtained, that is, (W1 - X1) / H1 ≥tan45°. As shown in combination with FIG. 9, where FIG. 9 is a schematic diagram of the positional relationship between a first touch sub-portion and a first opening according to some embodiments of the present invention, (W1 - X1) / H1 = tanθc1, and θc1 is an angle between a propagation direction of a first critical light ray emitted by the first light-emitting portion 211 and the normal of the substrate 1. The first critical light ray is the light ray emitted by the first light-emitting portion 211 that can just bypass the first touch sub-portion 41 to exit. That is to say, based on the arrangement provided by the embodiments of the present invention, θc1 ≥ 45° may be set, and only the large-angle light L12 with an emission angle of the first light-emitting portion 211 greater than or equal to 45° can be made to bypass the first touch sub-portion 41 and exit from the display panel 100. These large-angle light can interfere with the light emitted by the second light-emitting portion 212, achieving the large-angle anti-peeping of the display panel 100. In addition, the small-angle light L11 with an emission angle of the first light-emitting portion 211 less than 45° are made to be directed towards the first touch sub-portion 41 and be blocked by the first touch sub-portion 41, so as to prevent these small-angle light L11 from exiting from the display panel 100. Thus, the small-angle light emitted by the first light-emitting portion 211 will not enter the eyes of a user viewing the display panel 100 at an angle less than 45°. Users viewing the display panel at an angle less than 45° can only see the light emitted by the second light-emitting portion 212, which is beneficial to ensuring the display effect of the display panel 100 within a small viewing angle less than 45°, such as at the normal viewing angle.

Similarly, in the embodiments of the present invention, when the required anti-peeping viewing angle is 30°, k1 may be set to be equal to tan30°. Based on the above arrangement provided by the embodiments of the present invention, 0 < X1 ≤ W1 - H1×tan30°may be obtained, and (W1 - X1)/H1 ≥ tan30°. That is to say, θc1 ≥ 30° may be set, and only the large-angle light L12 with an emission angle of the first light-emitting portion 211 greater than or equal to 30° can be made to bypass the first touch sub-portion 41 and exit from the display panel 100. In addition, the small-angle light L11 with an emission angle of the first light-emitting portion 211 less than 30° are made to be directed towards the first touch sub-portion 41 and be blocked by the first touch sub-portion 41, so as to prevent these small-angle light L11 from exiting from the display panel 100.

In some embodiments of the present invention, as shown in FIG. 10, where FIG. 10 is a schematic diagram of another positional relationship between a first touch sub-portion and a first opening according to some embodiments of the present invention, an area of the first touch sub-portion 41 may also be made greater than or equal to an area of the first opening OP11. For example, the orthographic projection of the first touch sub-portion 41 on the plane of the substrate 1 may be made to cover the first opening OP11.

In this case, when arranging the first touch sub-portion 41 and the first opening OP11, In some embodiments of the present invention, as shown in FIG. 10, along the direction parallel to the plane of the substrate 1, a distance between an edge of the first touch sub-portion 41 and an edge of the first opening OP11 closest to it is X2, along the direction perpendicular to the plane of the substrate 1, a distance between the first touch sub-portion 41 and the first light-emitting portion 211 is H1, and a width of the first opening OP11 is W1. In some embodiments, X2 ≥ H1×k1 - W1, and X2 ≥ 0, where k1 is a constant. Here, k1 may be adjusted accordingly according to different requirements for the anti-peeping viewing angle.

For example, when the anti-peeping viewing angle is set to 45°, k1 may be set to be equal to tan45°. Based on the above arrangement provided by the embodiments of the present invention, X2 ≥ H1×tan45° - W1 may be obtained, and (W1 + X2)/H1 ≥ tan45°, where (W1 + X2)/H1 = tanθc1, and θc1 is the angle between the propagation direction of the first critical light ray emitted by the first light-emitting portion 211 and the normal of the substrate 1. That is to say, based on the arrangement provided by the embodiments of the present invention, θc1 ≥ 45° may be set, and only the large-angle light L12 with an emission angle of the first light-emitting portion 211 greater than or equal to 45° can be made to bypass the first touch sub-portion 41 and exit from the display panel 100, achieving the large-angle anti-peeping of the display panel 100. In addition, the small-angle light L11 with an emission angle of the first light-emitting portion 211 less than 45° are made to be directed towards the first touch sub-portion 41 and be blocked by the first touch sub-portion 41, so as to prevent these small-angle light from exiting from the display panel 100. Thus, the small-angle light L11 emitted by the first light-emitting portion 211 will not enter the eyes of a user viewing the display panel 100 at an angle less than 45°. Users viewing the display panel at an angle less than 45° can only see the light emitted by the second light-emitting portion 212, which is beneficial to ensuring the display effect of the display panel 100 within a small viewing angle less than 45°, such as at the normal viewing angle.

Similarly, when the required anti-peeping viewing angle is 30°, k1 may be set to be equal to tan30°. Based on the above arrangement provided by the embodiments of the present invention, X2 ≥ H1×tan30° - W1, and (W1 + X2)/H1 ≥ tan30°. That is to say, θc1 ≥ 30° may be set, and only the large-angle light L12 with an emission angle of the first light-emitting portion 211 greater than or equal to 30° may be made to bypass the first touch sub-portion 41 and exit from the display panel 100, achieving the large-angle anti-peeping of the display panel 100. In addition, the small-angle light L11 with an emission angle of the first light-emitting portion 211 less than 30° are made to be directed towards the first touch sub-portion 41 and be blocked by the first touch sub-portion 41, so as to prevent these small-angle light L11 from exiting from the display panel 100. Thus, the small-angle light L11 emitted by the first light-emitting portion 211 will not enter the eyes of a user viewing the display panel 100 at an angle less than 30°. Users viewing the display panel at an angle less than 30° can only see the light emitted by the second light-emitting portion 212, which is beneficial to ensuring the display effect of the display panel 100 within a small viewing angle less than 30°, such as at the normal viewing angle.

In some embodiments of the present invention, H1×k1 may be less than or equal to W1, that is, the above-mentioned H1×k1 - W1 may be negative. In the case where it is negative, X2 may be made greater than or equal to 0. For example, X2 may be made equal to 0, namely, the edge of the first touch sub-portion 41 and the edge of the first opening OP11 may be flush in the normal direction of the substrate 1. It should be noted that the edge of the first touch sub-portion 41 and the edge of the first opening OP11 may be misaligned within the allowable range of process errors, which may also be regarded as the edge of the first touch sub-portion 41 and the edge of the first opening OP11 being flush in the normal direction of the substrate 1.

When arranging the third opening OP22 and the second opening OP12, In some embodiments of the present invention, as shown in FIG. 2, an area of the third opening OP22 may be made larger than an area of the second opening OP12, and an orthographic projection of the second opening OP12 on the plane of the substrate 1 is made to be located within the third opening OP22. That is, the orthographic projection of the third opening OP22 on the plane of the substrate 1 is made to cover the orthographic projection of the second opening OP12 on the plane of the substrate 1, so that more small-angle light emitted by the second light-emitting portion 212 can exit through the third opening OP22, improving the display effect of the display panel 100 at the normal viewing angle.

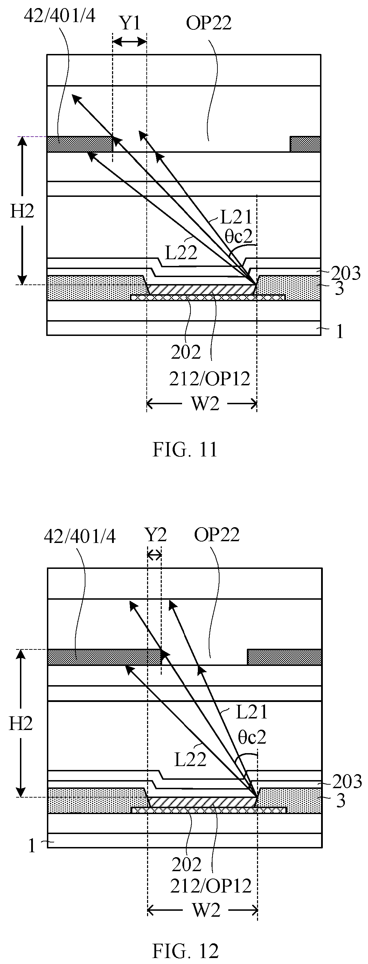

As shown in combination with FIG. 11, where FIG. 11 is a schematic diagram of the positional relationship between a third opening and a second opening according to some embodiments of the present invention, along the direction parallel to the plane of the substrate 1, a distance between an edge of the third opening OP22 and an edge of the second opening OP12 closest to it is Y1, and a width of the second opening OP12 is W2. In some embodiments of the present invention, as shown in FIG. 2, the width of the second opening OP12 on the side facing away from the substrate 1 may be greater than that on the side adjacent to the substrate 1. That is, the side surface of the second opening OP12 and the plane of the substrate 1 may be set as an inclined structure with an acute angle. The above-mentioned width W2 of the second opening OP12 may be the width of the second opening OP12 on the side facing away from the substrate 1.

Along the direction perpendicular to the plane of the substrate 1, a distance between the surface of the touch layer 4 facing away from the substrate 1 and the second light-emitting portion 212 is H2, and in some embodiments, 0 ≤ Y1 ≤ H2×k2 - W2, where k2 is a constant. k2 may also be adjusted accordingly according to different requirements for the anti-peeping viewing angle.

For example, when the anti-peeping viewing angle is set to 45°, k2 may be set to be equal to tan45°. Based on the above arrangement provided by the embodiments of the present invention, 0 ≤ Y1 ≤ H2×tan45° - W2 may be obtained, and (Y1 + W2) / H2 ≤ tan45°. That is to say, (Y1 + W2) / H2 = tanθc2, and θc2 is an angle between the propagation direction of a second critical light ray emitted by the second light-emitting portion 212 and the normal of the substrate 1. The second critical light ray is the light ray emitted by the second light-emitting portion 212 that can just pass through the third opening OP22 to exit. That is to say, based on the arrangement provided by the embodiments of the present invention, θc2 ≤ 45° may be set, and only the small-angle light L21 with an emission angle of the second light-emitting portion 212 less than or equal to 45° may be made to exit from the display panel 100 through the third opening OP22 and enter the eyes of a user viewing the display panel 100 at an angle less than or equal to 45°. The large-angle light L22 with an emission angle of the second light-emitting portion 212 greater than 45° are blocked by the second touch sub-portion 42 surrounding the third opening OP22, thereby reducing the amount of large-angle light emitted by the second light-emitting portion 212.

Similarly, when the anti-peeping viewing angle is set to 30°, k2 may be set to be equal to tan30°. Based on the above arrangement provided by the embodiments of the present invention, 0 ≤ Y1 ≤ H2×tan30° - W2 may be obtained, and (Y1 + W2)/H2 ≤ tan30°. That is to say, θc2 ≤ 30° may be set, and only the small-angle light L21 with an emission angle of the second light-emitting portion 212 less than or equal to 30° may be made to exit from the display panel 100 through the third opening OP22 and enter the eyes of a user viewing the display panel 100 at an angle less than or equal to 30°. The large-angle light L22 with an emission angle of the second light-emitting portion 212 greater than 30° are blocked by the second touch sub-portion 42 surrounding the third opening OP22, thereby reducing the amount of large-angle light emitted by the second light-emitting portion 212.

In some embodiments of the present invention, as shown in FIG. 12, where FIG. 12 is a schematic diagram of another positional relationship between a third opening and a second opening according to some embodiments of the present invention, an area of the third opening OP22 may also be made smaller than an area of the second opening OP12, and an orthographic projection of the third opening OP22 on the plane of the substrate 1 is made to be located within the second opening OP12. That is, the orthographic projection of the second opening OP12 on the plane of the substrate 1 is made to cover the orthographic projection of the third opening OP22 on the plane of the substrate 1.

Based on this arrangement, when arranging the third opening OP22 and the second opening OP12, In some embodiments of the present invention, as shown in FIG. 12, along the direction parallel to the plane of the substrate 1, a distance between an edge of the third opening OP22 and an edge of the second opening OP12 closest to it is Y2, along the direction perpendicular to the plane of the substrate 1, the distance between the surface of the touch layer 4 facing away from the substrate 1 and the second light-emitting portion 212 is H2, and the width of the second opening OP12 is W2, Y2 ≥ 0, and Y2 ≥ W2 - H2×k2, where k2 is a constant. Here, k2 may be adjusted accordingly according to different requirements for the anti-peeping viewing angle.

For example, when the anti-peeping viewing angle is set to 45°, k2 may be set to be equal to tan45°. Based on the above arrangement provided by the embodiments of the present invention, Y2 ≥ W2 - H2×tan45°may be obtained, and (W2 - Y2)/H2 ≤ tan45°, where (W2 - Y2)/H2 = tanθc2, and θc2 is the angle between the propagation direction of the second critical light ray emitted by the second light-emitting portion 212 and the normal of the substrate 1. The second critical light ray is the light ray emitted by the second light-emitting portion 212 that can just pass through the third opening OP22 to exit. That is to say, based on the arrangement provided by the embodiments of the present invention, θc2 ≤ 45° may be set, and only the small-angle light L21 with an emission angle of the second light-emitting portion 212 less than or equal to 45° may be made to exit from the display panel 100 through the third opening OP22 and enter the eyes of a user viewing the display panel 100 at an angle less than or equal to 45°. The large-angle light L22 with an emission angle of the second light-emitting portion 212 greater than 45° are blocked by the second touch sub-portion 42 surrounding the third opening OP22, thereby reducing the amount of large-angle light emitted by the second light-emitting portion 212.

Similarly, when the anti-peeping viewing angle is set to 30°, k2 may be set to equal to tan30°. Based on the above arrangement provided by the embodiments of the present invention, Y2 ≥ W2 - H2×tan30°may be obtained, and (W2 - Y2)/H2 ≤ tan30°. That is to say, θc2 ≤ 30° may be set, and only the small-angle light L21 with an emission angle of the second light-emitting portion 212 less than or equal to 30° may be made to exit from the display panel 100 through the third opening OP22 and enter the eyes of a user viewing the display panel 100 at an angle less than or equal to 30°. The large-angle light L22 with an emission angle of the second light-emitting portion 212 greater than 30° are blocked by the second touch sub-portion 42 surrounding the third opening OP22, thereby reducing the amount of large-angle light emitted by the second light-emitting portion 212.

In some embodiments of the present invention, W2 may be less than H2×K2, that is, the above-mentioned W2 - H2×k2 may be negative. In the case where it is negative, Y2 may be made greater than 0. For example, Y2 may be made equal to 0, namely, the edge of the third opening OP22 and the edge of the second opening OP12 may be made flush in the normal direction of the substrate 1. It should be noted that the edge of the third opening OP22 and the edge of the second opening OP12 may be misaligned within the allowable range of process errors, which may also be regarded as the edge of the third opening OP22 and the edge of the second opening OP12 being flush in the normal direction of the substrate 1.

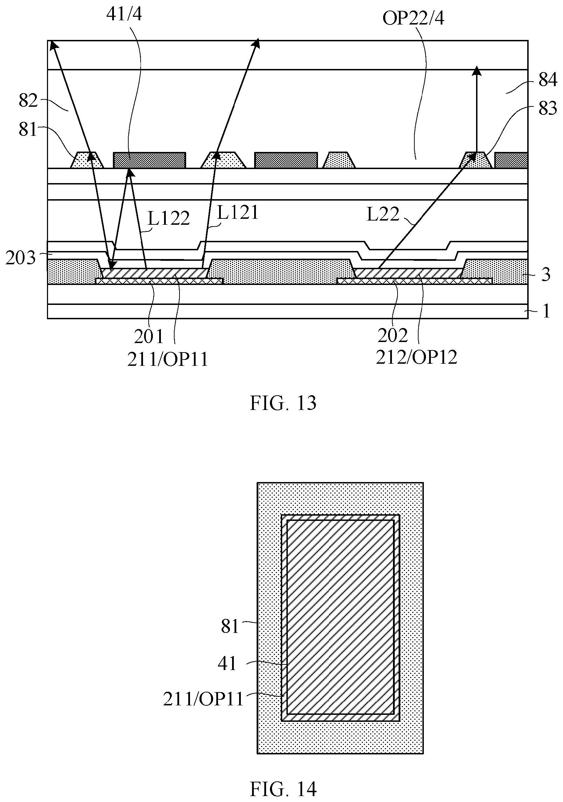

In some embodiments of the present invention, as shown in FIG. 13, where FIG. 13 is a cross-sectional view of another display panel according to some embodiments of the present invention. The display panel 100 further includes a first light-dimming portion 81 and a second light-dimming portion 82 arranged in a stacking manner. The first light-dimming portion 81 is located on a side of the second light-dimming portion 82 adjacent to the substrate 1, and a refractive index of the first light-dimming portion 81 is greater than that of the second light-dimming portion 82.

The first light-dimming portion 81 is configured to receive the light emitted by the first light-emitting portion 211 and adjust the propagation direction of these light, so that the emission angle of the light exited from the interface between the first light-dimming portion 81 and the second light-dimming portion 82 is greater than the incident angle of the incident light onto this interface. Here, the emission angle refers to the angle between the propagation direction of the emitted light and the normal of the substrate 1, and the incident angle refers to the angle between the propagation direction of the incident light and the normal of the substrate 1. With such an arrangement, the light intensity of the large-angle light exiting from the display panel 100 can be enhanced, which is beneficial to improving the large-angle anti-peeping effect of the display panel 100.

In some embodiments of the present invention, as shown in FIG. 13, some small-angle light L121 emitted by the first light-emitting portion 211 may be directed towards the first light-dimming portion 81 and exit from the interface between the first light-dimming portion 81 and the second light-dimming portion 82 at a larger emission angle. some other small-angle light L122 emitted by the first light-emitting portion 211 are directed towards the first touch sub-portion 41. After being reflected by the first touch sub-portion 41, these light are directed towards the first light-dimming portion 81 and exit from the interface between the first light-dimming portion 81 and the second light-dimming portion 82 at a larger emission angle.

In some embodiments of the present invention, the orthographic projection of the first light-dimming portion 81 on the plane of the substrate 1 may be made at least partially surround the first touch sub-portion 41. In some embodiments of the present invention, as shown in FIG. 14, where FIG. 14 is a top view of a first light-dimming portion, a first touch sub-portion, and a first light-emitting portion according to some embodiments of the present invention, the first light-dimming portion 81 is an annular structure surrounding the first touch sub-portion 41. The arrangement of the first light-dimming portion 81 can deflect the large-angle light reflected by the first touch sub-portion 41 again from multiple directions, increasing the large-angle light intensity in multiple directions, thereby improving the large-angle anti-peeping effect of the display panel 100 in multiple directions.

In some embodiments of the present invention, as shown in FIG. 13 and FIG. 14, along the direction parallel to the plane of the substrate 1, there may be a distance between the first touch sub-portion 41 and the first light-dimming portion 81.

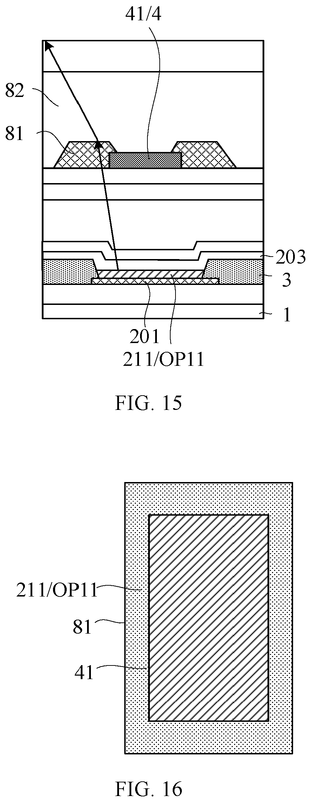

In some embodiments of the present invention, as shown in FIG. 15 and FIG. 16, where FIG. 15 is a cross-sectional view of another display panel according to some embodiments of the present invention and FIG. 16 is a top view of a first light-dimming portion, a first touch sub-portion, and a first light-emitting portion according to some embodiments of the present invention, at least part of the first light-dimming portion 81 is located on the side of the touch layer 4 facing away from the substrate 1. That is to say, along the direction perpendicular to the plane of the substrate 1, the first touch sub-portion 41 and the first light-dimming portion 81 at least partially overlap.

In some embodiments of the present invention, when manufacturing the display panel 100, the touch layer 4 may be prepared first. In some embodiments of the present invention, the preparation of the touch layer 4 includes processes such as film formation and patterning to form the first touch sub-portion 41 and the third opening OP22.

After the touch layer 4 is prepared, the first light-dimming portion 81 is prepared on the side of the touch layer 4 facing away from the substrate 1. In some embodiments of the present invention, as shown in FIG. 15, along the direction perpendicular to the plane of the substrate 1, the first light-dimming portion 81 and the first touch sub-portion 41 may partially overlap.

Thereafter, the second light-dimming portion 82 covering the first light-dimming portion 81 is formed. In some embodiments of the present invention, as shown in FIG. 13 and FIG. 15, the second light-dimming portion 82 includes a planarization layer. That is, the surface of the second light-dimming portion 82 facing away from the substrate 1 is a substantially flat plane.

In some embodiments of the present invention, as shown in FIG. 13, FIG. 14, FIG. 15 and FIG. 16, the orthographic projection of the first light-dimming portion 81 on the plane of the substrate 1 at least partially overlaps the first opening OP11, so as to receive as many small-angle light emitted by the first light-emitting portion 211 as possible, and adjust more small-angle light into large-angle light for emission, increasing the light intensity of the large-angle light exiting from the display panel 100 and improving the large-angle anti-peeping effect of the display panel.

In some embodiments of the present invention, as shown in FIG. 13, the display panel 100 further includes a third light-dimming portion 83 and a fourth light-dimming portion 84 arranged in a stacking manner. The third light-dimming portion 83 is located on the side of the fourth light-dimming portion 84 adjacent to the substrate 1, and the refractive index of the third light-dimming portion 83 is less than that of the fourth light-dimming portion 84.

As shown in FIG. 13, the orthographic projection of the third light-dimming portion 83 on the plane of the substrate 1 is at least partially located within the above-mentioned third opening OP22. The third light-dimming portion 83 is configured to receive the large-angle light L22 emitted by the second light-emitting portion 212 and adjust the propagation direction of these light, so that the emission angle of the light exiting from the interface between the third light-dimming portion 83 and the fourth light-dimming portion 84 is less than the incident angle of the incident light. With such an arrangement, the light intensity of the small-angle light exiting from the display panel 100 can be enhanced, which is beneficial to improving the display effect of the display panel at a small viewing angle, such as the normal viewing angle.

In some embodiments of the present invention, as shown in FIG. 13, the orthographic projection of the third light-dimming portion 83 on the plane of the substrate 1 at least partially does not overlap the second opening OP12, so as to avoid excessive small-angle light emitted by the second light-emitting portion 212 directed towards the third light-dimming portion 83, so that more small-angle light can bypass the third light-dimming portion 83 to exit, reducing light loss and increasing the brightness at the normal viewing angle.

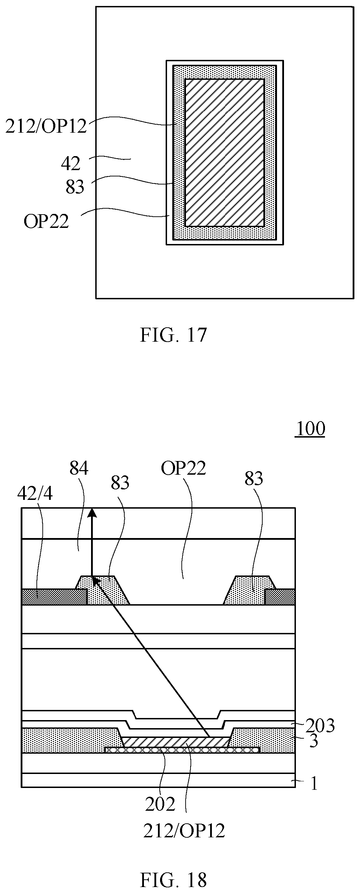

In some embodiments of the present invention, the orthographic projection of the third light-dimming portion 83 on the plane of the substrate 1 is made to at least partially surround the second opening OP12. In some embodiments of the present invention, as shown in FIG. 17, where FIG. 17 is a top view of a third light-dimming portion, a second touch sub-portion and a second light-emitting portion according to some embodiments of the present invention, the third light-dimming portion 83 is an annular structure surrounding the second opening OP12. The third light-dimming portion 83 can deflect the large-angle light emitted by the second light-emitting portion 212 in multiple directions, adjust more large-angle light into small-angle light to exit from the display panel, improving the utilization rate of the large-angle light emitted by the second light-emitting portion 212 and increasing the brightness of the display panel 100 at the normal viewing angle.

In some embodiments of the present invention, as shown in FIG. 13 and FIG. 17, along the direction parallel to the plane of the substrate 1, in the embodiments of the present invention, there may be a distance between the second touch sub-portion 42 and the third light-dimming portion 83. That is, there is a distance between the edge of the third light-dimming portion 83 and the edge of the third opening OP22.

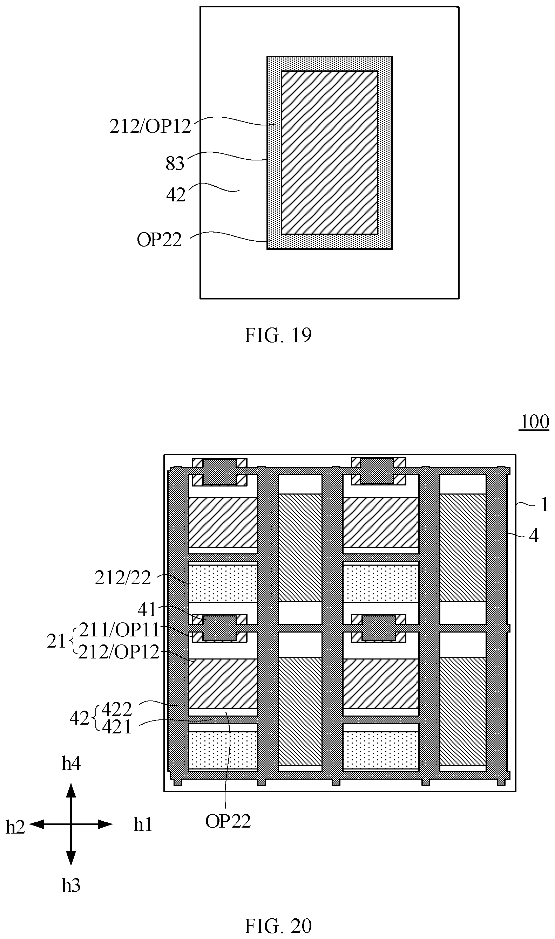

In some embodiments of the present invention, as shown in FIG. 18 and FIG. 19, where FIG. 18 is a cross-sectional view of another display panel according to some embodiments of the present invention, and FIG. 19 is a top view of a third light-dimming portion, a second touch sub-portion and a second light-emitting portion according to some embodiments of the present invention, the third light-dimming portion 83 and the second touch sub-portion 42 may be made to partially overlap, and at least part of the third light-dimming portion 83 is located on a side of the second touch sub-portion 42 facing away from the substrate 1.

In some embodiments of the present invention, as shown in FIG. 18, at least part of the third light-dimming portion 83 is located on the side of the touch layer 4 facing away from the substrate 1. In some embodiments of the present invention, when manufacturing the display panel 100, after the touch layer 4 is prepared, the third light-dimming portion 83 may be prepared on the side of the touch layer 4 facing away from the substrate 1. In some embodiments of the present invention, as shown in FIG. 18, along the direction perpendicular to the plane of the substrate 1, the third light-dimming portion 83 and the second touch sub-portion 42 may partially overlap. Thereafter, the fourth light-dimming portion 84 covering the third light-dimming portion 83 is formed.

In some embodiments of the present invention, the materials of the second light-dimming portion 82 and the fourth light-dimming portion 84 are the same, and they are formed by the same process to simplify the manufacturing process of the display panel, reduce the number of procedures, and lower the cost. In some embodiments of the present invention, there may be no interface between the second light-dimming portion 82 and the fourth light-dimming portion 84.

In some other embodiments, as shown in FIG. 20, where FIG. 20 is a top view of another display panel according to some embodiments of the present invention, the touch layer 4 includes the second touch sub-portion 42. The second touch sub-portion 42 at least partially surrounds the third opening OP22. Along the first direction h1 and/or the second direction h2, the second touch sub-portion 42 on a side of the second light-emitting portion 212 and the second light-emitting portion 212 at least partially overlap in the direction perpendicular to the plane of the substrate 1. The first direction h1 and the second direction h2 are opposite. Based on this arrangement, for the large-angle light emitted by the second light-emitting portion 212, these light can be blocked more by the second touch sub-portion 42 during exiting from the display panel 100. Therefore, for the optical components located on one side of the display panel 100 in the first direction h1 or for the optical components located on one side of the display panel 100 in the second direction h2, the light intensity of the large-angle light emitted by the second light-emitting portion 212 received by these optical components can be reduced. FIG. 20 shows, as an example, that along the first direction h1, the second touch sub-portion 42 on one side of the second light-emitting portion 212 and the second light-emitting portion 212 at least partially overlap in the direction perpendicular to the plane of the substrate 1, and along the second direction h2, the second touch sub-portion 42 on one side of the second light-emitting portion 212 and the second light-emitting portion 212 at least partially overlap in the direction perpendicular to the plane of the substrate 1.

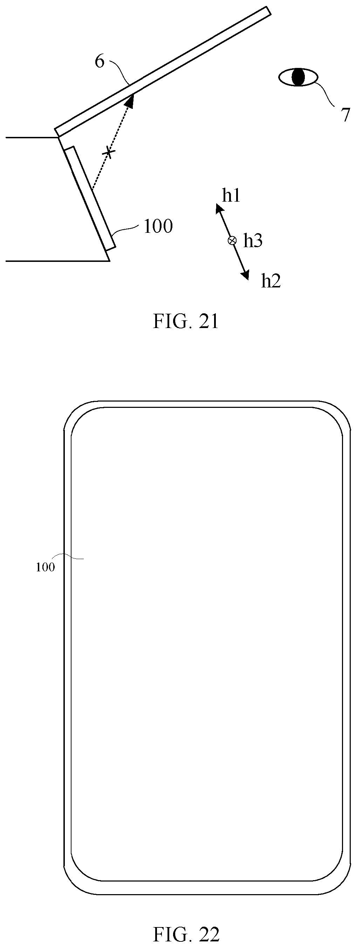

In some embodiments of the present invention, the display panel may be used for a vehicle-mounted display screen. In this case, the windshield in the vehicle may be regarded as the above-mentioned optical component. As shown in FIG. 21, where FIG. 21 is a schematic diagram of the positional relationship between a display panel and a windshield according to some embodiments of the present invention, along the first direction h1, the windshield 6 is located on one side of the display panel 100. In this way, the large-angle light emitted by the second light-emitting portion 212 can be blocked by the second touch sub-portion (not shown in FIG. 21) during being directed towards the windshield 6. Thus, these light can be prevented from being directed towards the windshield 6, and further, these light can be prevented from being reflected by the windshield 6 into the eyes of the primary driver. That is, it can avoid hindering the primary driver from observing the external environment of the vehicle through the windshield 6 due to the projection of the image of the display panel 100 on the windshield 6, which is beneficial to improving driving safety.

In some embodiments of the present invention, as shown in FIG. 20, along the third direction h3 and/or the fourth direction h4, the second touch sub-portion 42 on one side of the second light-emitting portion 212 and the second light-emitting portion 212 do not overlap in the direction perpendicular to the plane of the substrate 1. The third direction h3 and the fourth direction h4 are opposite, and the first direction h1 and the third direction h3 intersect and are both parallel to the plane of the substrate 1. Based on this arrangement, the blocking of the light emitted by the second light-emitting portion 212 by the second touch sub-portion 42 can be reduced. Moreover, when the display panel is used for a vehicle-mounted display screen, the third direction h3 may be parallel to the direction in which the primary driver's and the co - driver's seats are arranged. In some embodiments of the present invention, the first direction h1, the second direction h2, the third direction h3, and the fourth direction h4 may be the upper side direction, the lower side direction, the left side direction, and the right side direction of the vehicle-mounted display screen respectively. Based on this arrangement, the light emitted by the display panel 100 can avoid the second touch sub-portion 42 and be directed towards the primary driver on one side of the display panel 100 in the third direction h3 and towards the secondary driver on the other side of the display panel 100 in the third direction h3, so that the display screen can be viewed by both the primary driver and the secondary driver simultaneously. That is, the display screen can be shared by the primary driver and the secondary driver, which can improve the driving and riding experience.

It is noted that with such an arrangement, the second touch sub-portion 42 can limit the viewing angle of the display panel 100 in the first direction h1 or the second direction h2, and increase the viewing angle of the display panel 100 in the third direction h3 or the fourth direction h4.

In some embodiments of the present invention, as shown in FIG. 20, in the embodiments of the present invention, the first light-emitting portion 211 and the second light-emitting portion 212 may be arranged along the third direction h3 to avoid the blocking of the large-angle light emitted by the second light-emitting portion 212 and propagating towards the side of the third direction h3 by the first touch sub-portion 41 corresponding to the first light-emitting portion 211.

Based on the same inventive concept, the embodiments of the present invention also provide a display apparatus. As shown in FIG. 22, where FIG. 22 is a structural schematic diagram of a display apparatus according to some embodiments of the present invention, the display apparatus includes the above-mentioned display panel 100. The specific structure of the display panel 100 has been described in detail in the above embodiments, and will not be repeated here. In addition, the display apparatus shown in FIG. 22 is merely for illustrative purposes. The display apparatus may be any electronic device with a display function, such as a mobile phone, a tablet computer, a laptop computer, an e-book reader, a vehicle-mounted display screen, or a television.

The above are only the preferred embodiments of the present invention and are not intended to limit the present invention. Any modifications, equivalent replacements, improvements, etc. made within the spirit and principles of the present invention shall be included in the protection scope of the present invention.

Finally, it should be noted that the above embodiments are only used to illustrate the technical solutions of the present invention, not to limit them. Although the present invention has been described in detail with reference to the foregoing embodiments, those of ordinary skill in the art should understand that they can still modify the technical solutions described in the foregoing embodiments, or equivalently replace some or all of the technical features. These modifications or replacements do not cause the essence of the corresponding technical solutions to deviate from the scope of the technical solutions of the embodiments of the present invention.

## Claims

1. A display panel, comprising:
a substrate comprising a display region, wherein the display region comprises a plurality of light-emitting elements located on a side of the substrate, and the plurality of light-emitting elements comprises a first light-emitting element, the first light-emitting element comprises a first light-emitting portion and a second light-emitting portion;
a pixel definition layer located on a side of the substrate, wherein the pixel definition layer comprises a first opening and a second opening, at least part of the first light-emitting portion is located within the first opening, and at least part of the second light-emitting portion is located within the second opening; and
a touch layer located on a side of the light-emitting elements facing away from the substrate, wherein the touch layer comprises a first touch sub-portion and a third opening, along a direction perpendicular to a plane of the substrate, the first touch sub-portion at least partially overlaps the first opening, and the third opening at least partially overlaps the second opening.

2. The display panel of claim 1, wherein an orthographic projection of the first opening on the plane of the substrate covers an orthographic projection of the first touch sub-portion on the plane of the substrate.

3. The display panel of claim 2, wherein
along a direction parallel to the plane of the substrate, a distance between an edge of the first touch sub-portion and an edge of the first opening is X1;
along the direction perpendicular to the plane of the substrate, a distance between a surface of the first touch sub-portion adjacent to the substrate and the first light-emitting portion is H1; and
a width of the first opening on a side facing away from the substrate is W1, and X1 ≤ W1 - H1×k1, k1 being a constant.

4. The display panel of claim 1, wherein an orthographic projection of the first touch sub-portion on the plane of the substrate covers an orthographic projection of the first opening on the plane of the substrate.

5. The display panel of claim 4, wherein
along a direction parallel to the plane of the substrate, a distance between an edge of the first touch sub-portion and an edge of the first opening is X2;
along the direction perpendicular to the plane of the substrate, a distance between a surface of the first touch sub-portion adjacent to the substrate and the first light-emitting portion is H1; and
a width of the first opening on a side facing away from the substrate is W1, and X2 ≥ H1×k1 - W1, X2 ≥ 0, k1 being a constant.

6. The display panel of claim 1, wherein an orthographic projection of the third opening on the plane of the substrate covers an orthographic projection of the second opening on the plane of the substrate.

7. The display panel of claim 6, wherein
along a direction parallel to the plane of the substrate, a distance between an edge of the third opening and an edge of the second opening is Y1;
along the direction perpendicular to the plane of the substrate, a distance between a surface of the touch layer facing away from the substrate and the second light-emitting portion is H2; and
a width of the second opening on a side facing away from the substrate is W2, and 0 ≤ Y1 ≤ H2×k2 - W2, and k2 being a constant.

8. The display panel of claim 1, wherein an orthographic projection of the second opening on the plane of the substrate covers an orthographic projection of the third opening on the plane of the substrate.

9. The display panel of claim 8, wherein
along a direction parallel to the plane of the substrate, a distance between an edge of the third opening and an edge of the second opening is Y1;
along the direction perpendicular to the plane of the substrate, a distance between a surface of the touch layer facing away from the substrate and the second light-emitting portion is H2; and
a width of the second opening on a side facing away from the substrate is W2, and Y2 ≥ W2 - H2×k2, Y2 ≥ 0, and k2 being a constant.

10. The display panel of claim 1, further comprising a first light-dimming portion and a second light-dimming portion arranged in a stacking manner, wherein
the first light-dimming portion is located on a side of the second light-dimming portion adjacent to the substrate;
an orthographic projection of the first light-dimming portion on the plane of the substrate at least partially surrounds the first touch sub-portion; and
a refractive index of the first light-dimming portion is greater than a refractive index of the second light-dimming portion.

11. The display panel of claim 10, wherein an orthographic projection of the first light-dimming portion on the plane of the substrate at least partially overlaps the first opening.

12. The display panel of claim 10, wherein at least part of the first light-dimming portion is located on a side of the touch layer facing away from the substrate.

13. The display panel of claim 10, further comprising a third light-dimming portion and a fourth light-dimming portion arranged in a stacking manner, wherein
the third light-dimming portion is located on a side of the fourth light-dimming portion adjacent to the substrate;
an orthographic projection of the third light-dimming portion on the plane of the substrate is at least partially located within the third opening; and
a refractive index of the third light-dimming portion is less than a refractive index of the fourth light-dimming portion.

14. The display panel of claim 13, wherein at least part of an orthographic projection of the third light-dimming portion on the plane of the substrate does not overlap the second opening.

15. The display panel of claim 13, wherein at least part of the third light-dimming portion is located on a side of the touch layer facing away from the substrate.

16. The display panel of claim 13, wherein the second light-dimming portion and the fourth light-dimming portion are made of a same material, and formed by a same process.

17. The display panel of claim 1, wherein
the touch layer comprises a second touch sub-portion, and the second touch sub-portion at least partially surrounds the third opening;
along a first direction and/or a second direction, the second touch sub-portion on a side of the second light-emitting portion at least partially overlaps the second light-emitting portion in the direction perpendicular to the plane of the substrate; and
along a third direction and/or a fourth direction, the second touch sub-portion on a side of the second light-emitting portion does not overlap the second light-emitting portion in the direction perpendicular to the plane of the substrate, the first direction and the second direction being opposite to each other, the third direction and the fourth direction being opposite to each other, and the first direction intersecting with the third direction and both being parallel to the plane of the substrate.

18. The display panel of claim 1, wherein display modes of the display panel comprise an anti-peeping mode and a public mode;
in the anti-peeping mode, the first light-emitting portion and the second light-emitting portion emit light; and
in the public mode, the first light-emitting portion does not emit light, and the second light-emitting portion emits light.

19. The display panel of claim 18, wherein in the anti-peeping mode, brightness of the first light-emitting portion is greater than or equal to brightness of the second light-emitting portion.

20. The display panel of claim 1, wherein the plurality of light-emitting elements further comprises a second light-emitting element, and the second light-emitting element is provided with only a second light-emitting portion.

21. The display panel of claim 20, wherein the first light-emitting element comprises a green light-emitting element, and the second light-emitting element comprises a red light-emitting element or a blue light-emitting element.

22. A display apparatus, comprising the display panel of any of claims 1 to 21.
